# EUROPEAN PATENT APPLICATION

(11) **EP 4 722 831 A1**
(43) Date of publication of application: **08.04.2026**
(21) Application number: 24928333.4
(22) Date of filing: 08.03.2024
(51) Int. Cl.: G05B 19/4097, G05B 19/4068, G05B 19/4069

(54) **MODEL GENERATION METHOD, DETERMINATION METHOD, MACHINE TOOL SYSTEM, AND COMPUTER PROGRAM**

(71) Applicant: Yamazaki Mazak Corporation, Niwa-gun, Aichi 480-0197 (JP)
(72) Inventor: YAMAMOTO, Mikihito, Niwa-gun, Aichi 480-0197 (JP); SHIMADA, Yasutaka, Niwa-gun, Aichi 480-0197 (JP); TAKANO, Kazuyoshi, Niwa-gun, Aichi 480-0197 (JP); KOIKE, Shunsuke, Niwa-gun, Aichi 480-0197 (JP)
(74) Representative: TBK
(86) International application number: PCT/JP2024/009072
(87) International publication number: WO 2025/187051

(57) **Abstract**

A model generation method includes causing a processor to obtain from a storage, first data specifying a flange diameter that is a diameter of a flange of a tool holder in a radial direction with respect to a central axis, the tool holder including the flange formed around the central axis, and a holder main body which extends from the flange in an axial direction along the central axis and to which a rotary tool is attachable, and a flange length that is a length of the flange in the axial direction. The model generation method includes causing the processor to receive inputs of a shank diameter of the rotary tool and a main body length from an operator via an input interface, the main body length being a length of the holder main body in the axial direction. The model generation method includes causing the processor to obtain from the storage that stores correspondence between the shank diameter and a main body diameter that is a diameter of the holder main body in the radial direction, second data specifying the main body diameter corresponding to the shank diameter that has been received. The model generation method includes causing the processor to generate a geometric model of the tool holder based on the first data, the second data, and the main body length that has been received.

## Description

### Technical Field

The present invention relates to a model generation method, a determination method, a machine tool system, and a computer program.

### Background Art

Conventionally, a machine tool having an interference check function is known in order to prevent respective parts such as a tool, a table, a tool holder, and a workpiece from interfering with each other against the intention of an operator (for example, see Patent Document 1).

### Prior Art Document

### Patent Document 1

Japanese Patent No. 7303405

### SUMMARY OF THE INVENTION

### Problems to be Solved by the Invention

In the method related to Patent Document 1, it takes time and effort to create the holding unit model. Thus, the manufacturer of the machine tool provides the model of the tool holder, thereby reducing the burden on the operator to create the holding unit model. However, in the machine tool (for example, a machining center) that operates the rotary tools, various tool makers supply the tool holder, and thus it is difficult for the maker of the machine tool to provide the geometric models of all the tool holders in advance. Therefore, in the case of the tool holder other than the model provided by the manufacturer of the machine tool, there is a burden of obtaining the geometric model of the tool holder from the tool manufacturer or creating the shape model of the tool holder by the operator.

The object of the technology disclosed in the present application is to provide a model generation method, a determination method, a machine tool system, and a computer program, capable of generating a geometric model of a tool holder mounted on a machine tool for operating a rotary tool more easily than before.

### Means for Solving the Problems

According to a first aspect of the present disclosure, a model generation method includes causing a processor to obtain from a storage, first data specifying a flange diameter that is a diameter of a flange of a tool holder in a radial direction with respect to a central axis, the tool holder including the flange formed around the central axis, and a holder main body which extends from the flange in an axial direction along the central axis and to which a rotary tool is attachable, and a flange length that is a length of the flange in the axial direction. The model generation method includes causing the processor to receive inputs of a shank diameter of the rotary tool and a main body length from an operator via an input interface, the main body length being a length of the holder main body in the axial direction. The model generation method includes causing the processor to obtain from the storage that stores correspondence between the shank diameter and a main body diameter that is a diameter of the holder main body in the radial direction, second data specifying the main body diameter corresponding to the shank diameter that has been received. The model generation method includes causing the processor to generate a geometric model of the tool holder based on the first data, the second data, and the main body length that has been received.

According to a second aspect of the present disclosure, in the model generation method according to the first aspect, causing the processor to receive the input of the main body length from the operator includes causing the processor to receive from the operator an input of a holder overall length that is a sum of the main body length and the flange length, and causing the processor to obtain the main body length by subtracting the flange length from the holder total length.

According to a third aspect of the present disclosure, in the model generation method according to the first or second aspect, causing the processor to receive, via the input interface, from the operator, an input of holder type information specifying a type of the tool holder attachable to a machine tool, and causing the processor to obtain the first data based on the holder type information from a storage that stores correspondence that associates the holder type information with the flange diameter and the flange length corresponding to the holder type information.

According to a fourth aspect of the disclosure, in the model generation method according to the third aspect, the tool holder has a holder shank opposite to the holder main body with respect to the flange in the axial direction. A spindle of the machine tool has a reception hole into which the holder shank is insertable. Whether or not the plurality of the tool holders are attachable to the machine tool is determined based on whether or not the reception hole fits the holder shank.

According to a fifth aspect of the present disclosure, in the model generation method according to any one of the first to fourth aspects, the main body diameter is equal to an outer diameter of a nut with which the rotary tool is fastened to the holder main body.

According to a sixth aspect of the present disclosure, in the model generation method according to the fifth aspect, the nut is configured to fasten a collet that is capable of press-fittable onto the rotary tool that has the shank diameter.

According to a seventh aspect of the present disclosure, in the model generation method according to the sixth aspect, the outer diameter of the nut is determined to a dimension corresponding to a size of the collet that fits with the shank diameter in accordance with the ISO15488 standard.

According to an eighth aspect of the present disclosure, the model generation method according to any one of the first to seventh aspects further includes causing the processor to receive via the input interface from the operator, an input of at least one revised value of the flange diameter, the flange length, the main body diameter, and the main body length, and causing the processor to regenerate the geometric model of the tool holder based on the at least one revised value when the at least one revised value is input.

According to a ninth aspect of the present disclosure, the model generation method according to any one of the first to eighth aspects further includes causing the processor to receive via the input interface from the operator, an input of a tool-length offset, which is a length of a protrusion of the rotary tool from the nut, causing the processor to acquire from the storage, third information defining a shape of a rotary tool, causing the processor to generate a geometric model of the rotary tool based on the tool-length offset and the third data; and causing the processor to generate an assembly model by combining the geometric model of the rotary tool and the geometric model of the tool holder.

According to a tenth aspect of the present disclosure, the model generation method of the ninth aspect further includes causing the processor to generate a signal to a display to cause the display to display the assembly model, causing the processor to receive via the input interface, an input of at least one revised value of the flange diameter, the flange length, the main body diameter, the main body length, and the tool-length offset, causing the processor to regenerate the assembly model based on the at least one revised value upon the input of the at least one revised value.

According to an eleventh aspect of the present disclosure, a determination method includes the model generation method according to the ninth aspect or the tenth aspect, causing the processor to acquire from the storage, a geometric model of an obstacle including a measurement instrument configured to measure the tool-length offset; and causing the processor to determine whether or not the assembly model and the geometric model of the obstacle interfere with each other before the geometric model of the rotary tool reaches a predetermined position of the measurement position when executing a moving program of the rotary tool so as to have the rotary tool measured by the measurement instrument.

According to an twelfth aspect of the present disclosure, a determination method includes the model generation method according to any one of the ninth aspect and the tenth aspect and causing the processor to acquire a geometric model of an obstacle from the storage, and causing the processor to determine whether or not the assembly model and the geometric model of the obstacle interfere with each other when the machine tool is caused to execute a machining program to machine the workpiece by driving the spindle.

According to a thirteenth aspect of the present disclosure, a computer includes a processor configured to execute the model generation method according to according to the first aspect or the tenth aspect or the determination method according to the eleventh or the twelfth aspect, the storage, and the input interface.

According to a fourteenth aspect of the present disclosure, a machine tool system a includes the computer according to the thirteenth aspect and the machine tool includes the spindle to which the tool holder is attachable.

According to a fifteenth aspect of the present disclosure, a computer program includes instructions which, when executed by a computer with an input interface, cause the computer to carry out the model generation method according to any one of first aspect to tenth aspect or the determination method according to eleventh aspect or twelfth aspect.

According to a sixteenth aspect of the present disclosure, a computer-readable medium includes instructions which, when executed by a computer with an input interface, cause the computer to carry out the model generation method according to any one of first aspect to tenth aspect or the determination method according to eleventh aspect or twelfth aspect..

In the model generation method according to the first aspect, the computer according to the thirteenth aspect including a hardware processor configured to execute the processing of the model generation method according to the first aspect, the machine tool system according to the fourteenth aspect including the computer, the computer program according to the fifteenth aspect including an instruction for causing a computer to execute the model generation method according to the first aspect, and the computer-readable medium according to the sixteenth aspect including an instruction for causing a computer to execute the model generation method according to the first aspect, the diameters and lengths of the flanges of the tool holder are obtained from the storage, and the diameters of the holder main body of the tool holder are automatically obtained from the diameters of the shanks, which are one of the shapes of the rotary tools that are separately input. Therefore, the model of the tool holder can be generated by the operator inputting only the parameter related to the main body length of the holder main body. Therefore, the tool holder model can be generated more easily than in the related art.

In the model generation method according to the second aspect, the computer according to the thirteenth aspect including a hardware processor configured to execute the model generation method according to the second aspect, the machine tool system according to the fourteenth aspect comprising the computer, the computer program according to the fifteenth aspect including instructions for causing a computer to execute the model generation method according to the second aspect, and the computer-readable medium according to the sixteenth aspect including instructions for causing a computer to execute the model generation method according to the second aspect, obtained from the diameters of the shanks, which are one of the shapes of the rotary tools that are separately input.

In the model generation method according to the third aspect, the computer according to the thirteenth aspect including a hardware processor configured to execute the process of the model generation method according to the third aspect, the machine tool system according to the fourteenth aspect including the computer, the computer program according to the fifteenth aspect including an instruction to cause a computer to execute the model generation method according to the third aspect, and the computer-readable medium according to the sixteenth aspect including an instruction to cause a computer to execute the model generation method according to the third aspect, the flange diameter and the flange length of the tool holder are set by inputting the holder type information, and thus the usability for the operator can be further improved.

In the model generation method according to the fourth aspect, the computer according to the thirteenth aspect including a hardware processor configured to execute the processing of the model generation method according to the fourth aspect, the machine tool system according to the fourteenth aspect including the computer, the computer program according to the fifteenth aspect including an instruction for causing a computer to execute the model generation method according to the fourth aspect, and the computer-readable medium according to the sixteenth aspect including an instruction for causing a computer to execute the model generation method according to the fourth aspect, since the shape of the holder is determined so that the reception hole of the spindle matches the holder shank, the holder which is determined can be reliably mounted on the spindle.

In the model generation method according to the fifth aspect, the computer according to the thirteenth aspect comprising a hardware processor configured to execute the model generation method according to the fifth aspect, the machine tool system according to the fourteenth aspect comprising the computer, the computer program according to the fifteenth aspect comprising instructions for causing a computer to execute the model generation method according to the fifth aspect, and the computer-readable medium according to the sixteenth aspect comprising instructions for causing a computer to execute the model generation method according to the fifth aspect, the main body diameter is obtained from the shank diameter by utilizing the fact that the outer diameter of the nut for fixing the rotary tool to the holder main body and the shank diameter are correlated with each other.

In the model generation method according to the sixth aspect, the computer according to the thirteenth aspect comprising a hardware processor configured to execute the model generation method according to the sixth aspect, the machine tool system according to the fourteenth aspect comprising the computer, the computer program according to the fifteenth aspect comprising instructions for causing a computer to execute the model generation method according to the sixth aspect, and the computer-readable medium according to the sixteenth aspect comprising instructions for causing a computer to execute the model generation method according to the sixth aspect, the rotary tool is press-fit by the collet, so that the rotary tool is securely fixed to the tool holder.

In the model generation method according to the seventh aspect, the computer according to the thirteenth aspect comprising a hardware processor configured to execute the model generation method according to the seventh aspect, the machine tool system according to the fourteenth aspect comprising the computer, the computer program according to the fifteenth aspect comprising instructions for causing a computer to execute the model generation method according to the seventh aspect, and the computer-readable medium according to the sixteenth aspect comprising instructions for causing a computer to execute the model generation method according to the seventh aspect, the correlation between the outer diameter of the nut and the shank diameter is determined based on the international standard, and thus many tool holder shapes compatible with the international standard can be handled.

In the model generation method according to the eighth aspect, the computer according to the thirteenth aspect comprising a hardware processor configured to execute the model generation method according to the eighth aspect, the machine tool system according to the fourteenth aspect comprising the computer, the computer program according to the fifteenth aspect comprising instructions for causing a computer to execute the model generation method according to the eighth aspect, and the computer-readable medium according to the sixteenth aspect comprising instructions for causing a computer to execute the model generation method according to the eighth aspect, it is possible to improve the usability for the operator because the dimensions of the tool holder can be corrected after being displayed on the display.

In the model generation method according to the ninth aspect, the computer according to the thirteenth aspect comprising a hardware processor configured to execute the model generation method according to the ninth aspect, the machine tool system according to the fourteenth aspect comprising the computer, the computer program according to the fifteenth aspect comprising instructions for causing a computer to execute the model generation method according to the ninth aspect, and the computer-readable medium according to the sixteenth aspect comprising instructions for causing a computer to execute the model generation method according to the ninth aspect, since the assembly model can be generated by combining the geometric model of the of the rotary tool and the geometric model of the tool holder, interference between the assembly model and the workpiece can be detected and the tool protrusion instruction can be simulated.

In the model generation method according to the tenth aspect, the computer according to the thirteenth aspect including a hardware processor configured to execute the process of the model generation method according to the tenth aspect, the machine tool system according to the fourteenth aspect including the computer, the computer program according to the fifteenth aspect including an instruction for causing a computer to execute the model generation method according to the tenth aspect, and the computer-readable medium according to the sixteenth aspect including an instruction for causing a computer to execute the model generation method according to the tenth aspect, it is possible to improve the usability for the operator because the dimensions of the tool holder can be corrected after being displayed on the display.

In the determination method according to the eleventh aspect, the computer according to the thirteenth aspect comprising a hardware processor configured to execute the processing of the determination method according to the eleventh aspect, the machine tool system according to the fourteenth aspect comprising the computer, the computer program according to the fifteenth aspect comprising instructions for causing a computer to execute the determination method according to the eleventh aspect, and the computer-readable medium according to the sixteenth aspect comprising instructions for causing a computer to execute the determination method according to the eleventh aspect, in the simulation, a path in which the rotary tool does not interfere with the obstacle can be set. Therefore, the rotary tool can be moved at a high speed to a position as close to the measurement instrument as possible, and then can be inserted into the measurement instrument at a low approach speed. Alternatively, conventionally, since the amount of protrusion of the tool is not known, in order to avoid interference between the tool and the measurement instrument, it is necessary to move the tool to the measurement of the tool at a predetermined position with the machine origin as the start point of the tool measurement. However, since the protrusion amount of the tool is clear from the protrusion instruction, the measurement can be performed by moving to the tool measurement at a predetermined position with a position closer to the tool measurement instrument than the machine origin as a start point of the tool measurement. As a result, the measurement time of the tool measurement can be shortened.

In the determination method according to the twelfth aspect, the computer according to the thirteenth aspect comprising a hardware processor configured to perform the processing of the determination method according to the twelfth aspect, the machine tool system according to the fourteenth aspect comprising the computer, the computer program according to the fifteenth aspect comprising instructions for causing a computer to perform the determination method according to the twelfth aspect, and the computer-readable medium according to the sixteenth aspect comprising instructions for causing a computer to perform the determination method according to the twelfth aspect can simulate interference detection between an assembly model and an obstacle. Further, the size of the tool length offset to the extent that the tool holder does not interfere with the workpiece can be checked in advance by simulation.

### Effects of the Invention

According to the technique disclosed in the present application, the model generation method, the determination method, the machine tool system, and the computer program can be provided that can generate the geometric model of the tool holder attached to the machine tool that operates the rotary tools more easily than in the related art.

### BRIEF DESCRIPTION OF DRAWINGS

FIG. 1 is a diagram showing an external configuration of a machine tool system according to an embodiment.
FIG. 2 is a diagram showing the configuration of an electronic circuit of the machine tool according to the embodiment.
FIG. 3 is an enlarged perspective view showing a tool magazine and a tool-changing device.
FIG. 4 is a sectional view showing an outline of a machining head of the machine tool shown in FIG. 1.
FIG. 5 is an enlarged view of the tool holder and the rotary tool.
FIG. 6 is an enlarged view of the collet and its surroundings.
FIG. 7 is an example of flange definition data.
FIG. 8 is an example of holder main body definition data.
FIG. 9 is an example of an input interface of the tool interface.
FIG. 10 shows an example of an input interface for a shank diameter of a rotary tool.
FIG. 11 shows an example of the input interface for the body length of the tool holder.
FIG. 12 is a diagram showing a modification of the holder shape data.
FIG. 13 shows an example of the display of an additional menu.
FIG. 14 shows an example of a detailed shape input screen.
FIG. 15 is a conceptual diagram showing the movement of the rotary tool to the measuring device.
FIG. 16 is a flowchart showing the details of the operation of the model generation program.
FIG. 17 is a flowchart showing the details of the operation in step S1.
FIG. 18 is a flowchart showing the details of the operation in step S5.

### Detailed Description of the Invention

The present invention will be described in detail below with reference to the drawings showing embodiments thereof. In the drawings, the same reference numerals denote corresponding or substantially the same components.

### <Embodiment>

### <Configuration of Machine Tool>

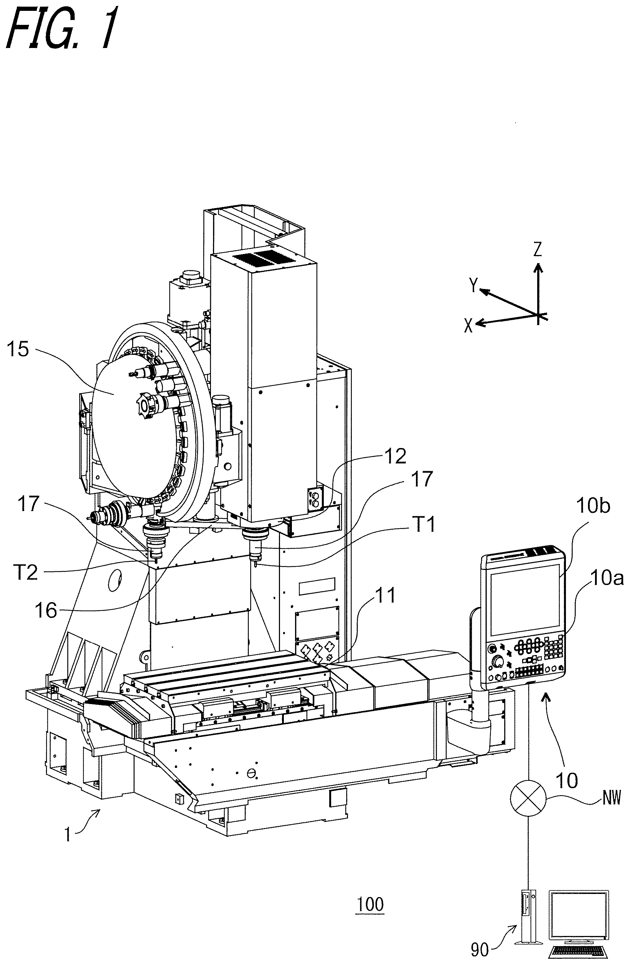

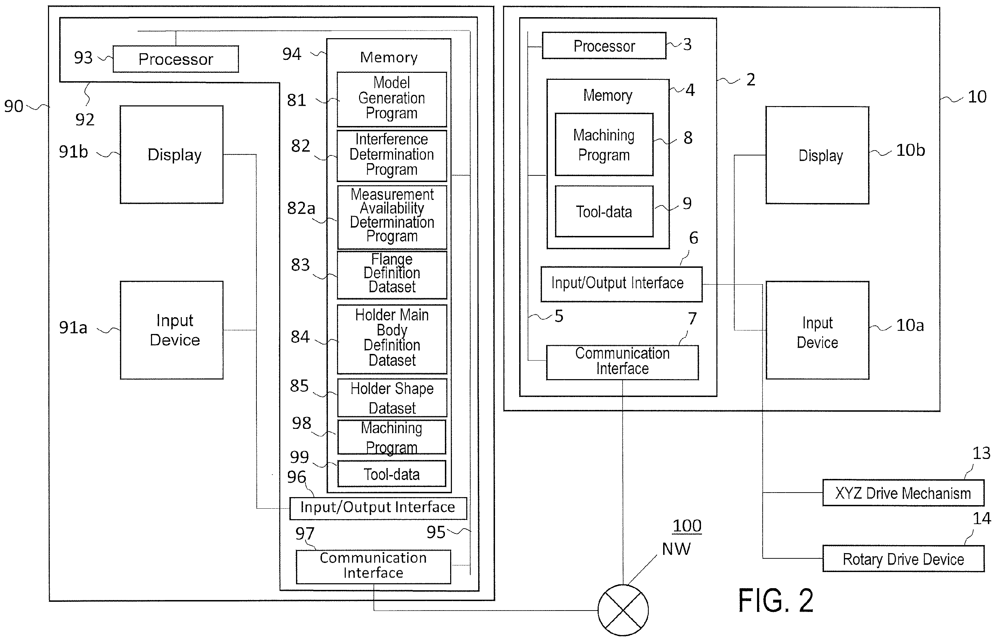

FIG. 1 is a diagram showing an external configuration of a machine tool system including a machine tool 1 according to an embodiment of the present invention. FIG. 2 is a diagram showing a configuration of an electronic circuit of the machine tool system 100 according to the embodiment. The machine tool system 100 includes a machine tool 1 and a computer 90 connected to the machine tool 1 via a network NW. The computer 90 may be a general-purpose computer including electronic circuits such as a hardware processor and a memory. The computer 90 is used to perform simulation when the machining program is executed by the machine tool 1. The network NW may be a wired network such as an intranet or a wireless network such as a wireless LAN.

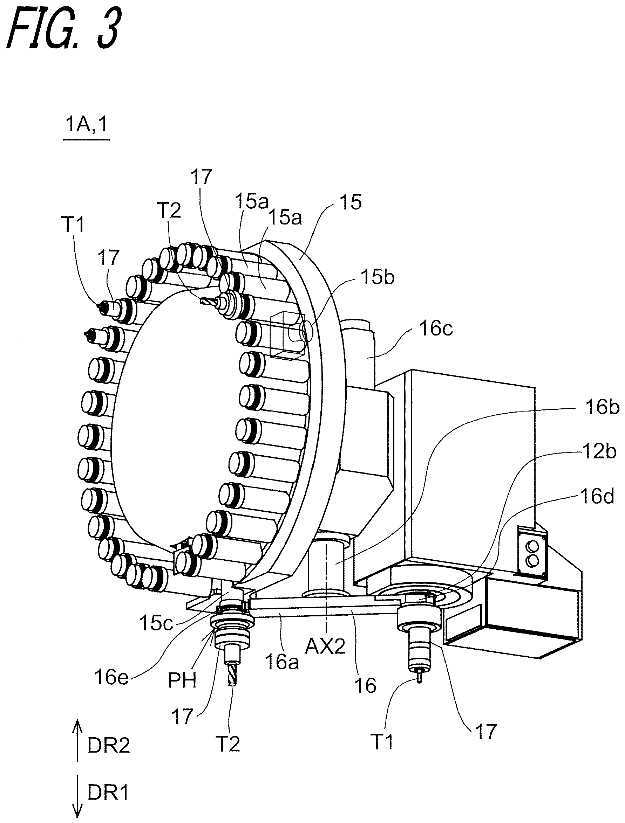

As shown in FIG. 1, the machine tool 1 includes a control panel 10, a machining table 11 for holding a workpiece W (see FIG. 3), a machining head 12 that is movable in XYZ directions with respect to the workpiece W, a tool magazine 15, and a tool-changing device 16. The tool magazine 15 can accommodate both the tool holder 17 for holding the rotary tools T1 and the tool holder 17 for holding other rotary tools T2. Although not shown in FIG. 1, the machine tool 1 may further include a cover that covers the above-described components other than the control panel 10.

Referring to FIG. 2, the control panel 10 includes a numerical controller 2 for controlling the operation of the machine tool 1, and keys, buttons, dials, touch panels, input devices 10a and the like for an operator to input machining conditions and the like in machining control executed by the numerical controller 2, and a display 10b for displaying the machining conditions, etc., to an operator. The numerical controller 2 includes a hardware processor 3, a memory 4, a bus 5, an input/output interface 6, and a communication interface 7. The communication interface 7 is configured to communicate with the computer 90 via the network NW. The memory 4 stores a machining program 8 such as a machining program and a tool-data 9 representing the shape of the plurality of rotary tools T1. The memory 4 may be referred to as a storage. The hardware processor 3 executes various programs. In the following embodiments, the hardware processor 3 may be simply referred to as a processor 3.

FIG. 3 is an enlarged perspective view showing a tool magazine 15 and a tool-changing device 16. The magazine 15 includes a plurality of holders 15a for holding the plurality of tool holders 17, and a holder moving device 15b for moving the plurality of holders 15a along the peripheral track. The plurality of holders 15a are assigned with pocket numbers "PKNo." to be distinguished from each other. T numbers "TNo." are assigned to the rotary tools T1 held by the plurality of holder 15a via the tool holder 17, respectively. In the tool-data 9, T numbers corresponding to pocket numbers, and shapes of the rotary tools T1 corresponding to the T numbers, and the like are stored in association with each other. The tool magazine 15 may have a holder removing device 15c for moving the tool holder 17 stored in the tool magazine 15 to a standby position PH accessible by the tool-changing device 16.

The tool-changing device 16 is configured to change tools between the tool magazine 15 and the spindle 12b. The tool-changing device 16 includes a tool-changing arm 16a, an arm rotation device 16b for rotating the tool-changing arm 16a, and an arm moving device 16c for linearly moving the tool-changing arm 16a. The arm rotation device 16b rotates the tool-changing arm 16a about the arm rotation axis AX2. The arm moving device 16c moves the tool-changing arm 16a in a direction parallel to the arm rotation axis AX2 (a first direction DR1 and a second direction DR2 in FIG. 3). The tool-changing device 16 has gripping portions 16d and 16e having a configuration similar to a magic hand capable of gripping the tool holder 17 before and after the change.

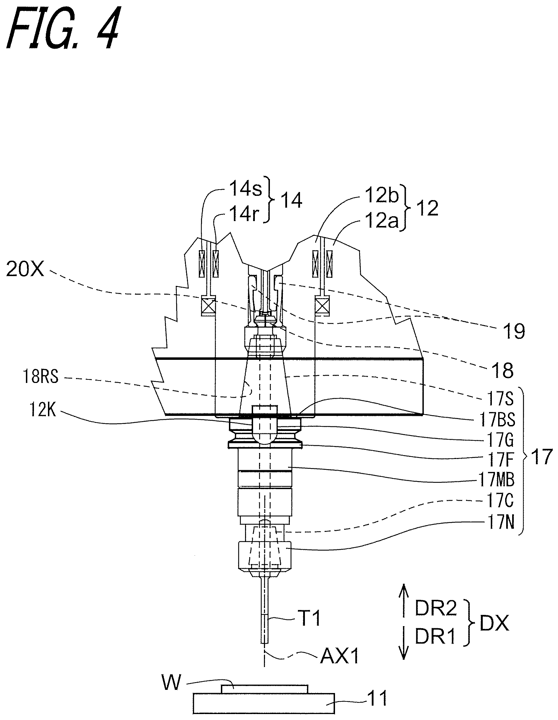

FIG. 4 is a sectional view showing an outline of a machining head 12 of the machine tool 1 shown in FIG. 1. As shown in FIG. 4, the machining head 12 includes a spindle frame 12a having a hollow housing structure and a spindle 12b contained in the spindle frame 12a. The spindle frame 12a of the machining head 12 is attached to the drive mechanism 13 shown in FIG. 2 and is movable in three axial directions of XYZ. One end of the spindle 12b is connected to a rotary drive device 14 such as a motor, for example, and is configured to rotate around the rotation axis AX1. The rotary drive device 14 includes a stator 14s fixed to the spindle frame 12a and a rotor 14r fixed to the spindle 12b. XYZ drive mechanism 13 and the rotary drive device 14 is connected to the numerical controller 2 via the input/output interface 6.

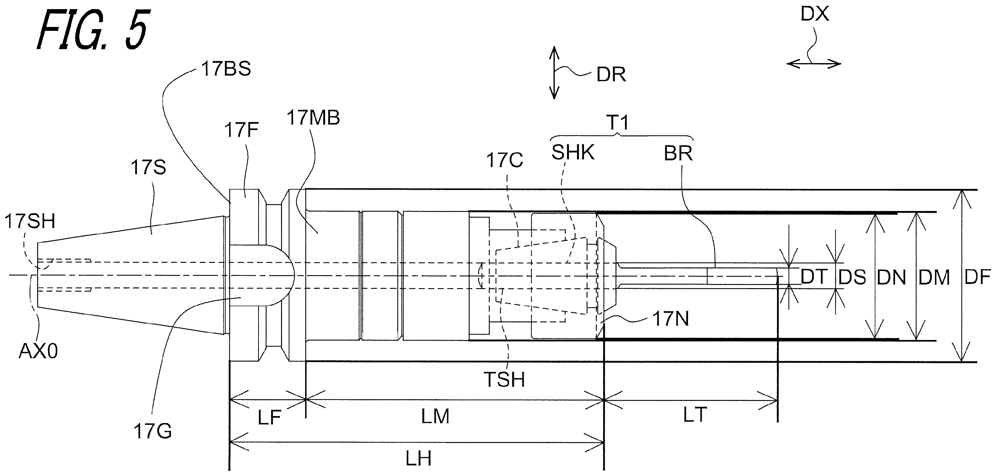

A tool holder 17 is detachably attached to the lower end of the spindle 12b. FIG. 4 shows a rotary-tool T1 according to the embodiment. The rotary tool T1 is a tool for machining. The rotary tool T1 is held by the tool holder 17. A pull stud 18 is attached to the upper end of the tool holder 17. FIG. 5 is an enlarged view of the tool holder 17 and the rotary tool T1 excluding the pull stud 18. As shown in FIG. 5, the tool holder 17 includes a holder shank 17S, a flange 17F, a holder main body 17MB, a collet 17C, and a nut 17N. The holder shank 17S has a substantially truncated conical shape that is a rotating body about the central axis AX0. The central axis AX0 substantially coincides with the rotation axis AX1 when the tool holder 17 is attached to the spindle 12b. The term "substantially coincide" means that a deviation within the range of the mounting error of the tool holder 17 is allowed. The holder shank 17S may have a substantially truncated triangular pyramidal shape like a CAPTO (trademark) shank. The holder shank 17S has a screw hole 17SH for screwing the pull stud 18, and the pull stud 18 is connected to the holder shank 17SH by screwing a male screw portion (not illustrated) of the pull stud 18 into the screw hole 17S.

The flange 17F is formed around the central axis AX0. The flange 17F includes a seat surface 17BS that can abut on the spindle 12b. Depending on the type of the tool holder 17, the seat surface 17BS may not be in contact with the spindle 12b but may face the spindle 12b. The flange 17F has a flange length LF which is perpendicular to the seat surface 17BS and which is measured in the direction of the central axis AX0. The flange 17F has a flange diameter DF which is a length of the radial direction DR (perpendicular to the axial direction) with respect to the central axis AX0. The flange 17F protrudes from the holder shank 17S and the holder main body 17MB in the radial direction DR. The flange 17F has a groove 17G cut in the radial direction DR.

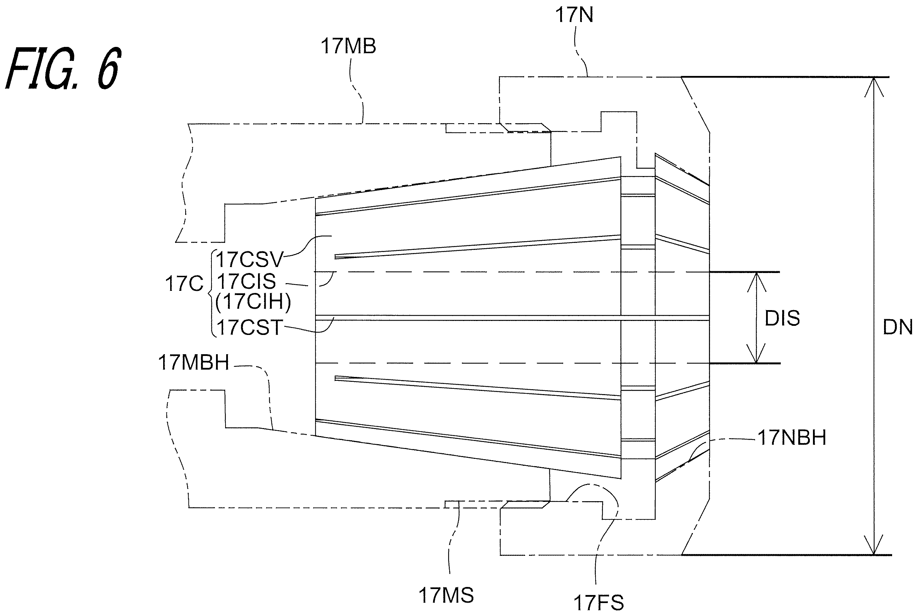

The holder main body 17MB protrudes from the flange 17F in the axial direction DX. The holder main body 17MB has a main body width LM that is a length of the axial direction DX and a main body height DM which is a radial direction DR. The sum of the flange length LF and the main body length LM is referred to as a holder total length LH, and the main body length LM may be obtained as a value obtained by subtracting the flange length LF from the holder total length LH. The holder shank 17S and the holder main body 17MB are arranged axially opposite one another with respect to the flange 17F. The rotary tool T1 is attachable to the holder main body 17MB. To be more specific, referring to FIG. 6, the holder main body 17MB has a reception hole 17MBH into which the collet 17C is inserted, and a male screw portion 17MS engageable with the nut 17N.

FIG. 6 is an enlarged view of the collet 17 and its surroundings. The collet 17C includes a tapered sleeve 17CSV having a cylindrical inner surface 17CIS and a plurality of slit 17CSL. The nut 17N has a reception hole 17NBH into which the collet 17C is inserted and a female screw portion 17FS which can be engaged with the male screw portion 17MS. The nut 17N is used to fix the rotary tool T1 to the holder main body 17MB. In particular, the nut 17N is configured to clamp a collet 17C that can press fit a rotary tool T1. When the nut 17C with the collet 17N inserted therein is screwed into the holder main body 17MB, the sleeve 17CSV is pressed against the wall surface of the reception hole 17MBH in the axial direction DX, whereby the collet 17C is compressed and firmly fastens the shanks SHK of the rotary tools T1 inserted into the insertion hole (17CIA) defined by the inner surfaces 17CIS. That is, the diameter DIS of the insertion hole 17CIH changes according to the degree of fastening of the collet 17C.

Referring to FIG. 5, the rotary tool T1 have shanks SHK which are inserted into the insertion hole 17CIH of the collet 17C on the blade BR and on opposite side of the blade BR. The blade BR has a tool diameter DT which is a diameter in the radial direction DR. The rotary tool T1 has a tool-length offset LT which is a protrusion from the nut 17N. The shank SHK has a shank diameter DS which is a diameter in the radial direction DR. Since the range of variation of the diameter DIS of the insertion hole 17CIH is limited, the collet 17C to be used is limited when the shank diameter DS is determined. The ISO15488 defines the shape of the nut 17C to be used, the shape of the reception hole 17MBH of the holder main body 17MB, and the shape of the male screw portion 17MS, which correspond to the specifications of the collet 17C. Therefore, when the shank diameter DS is determined, the outer diameter DN of the nut 17N is substantially determined by the standard. That is, the outer diameter DN of the nut 17N is determined to correspond to the size of the collet 17C conforming to the shank diameter DS based on the ISO15488 standard.

Returning to FIG. 4, the spindle 12b includes a collet chuck 19 that can be fitted to the pull stud 18 and a key 12K that can be fitted to the groove 17G. The collet chucks 19 are movable in the axial direction DX along the rotation axis AX1 of the spindle 12b. The spindle 12b has a reception hole 18RS into which the holder shank 17S can be inserted so that the central axis AX0 in FIG. 5 and the rotation axis AX1 in FIG. 4 coincide with each other when the holder main body 17MB and the rotary tool T1 are attached to the spindle 12b. The shape of the reception hole 18RS is based on the tool interface supported by the machine tool 1 (spindle 12b). That is, whether or not the plurality of tool holders 17 can be mounted on the machine tool 1 is determined based on whether or not the reception hole 18RS matches the holder shank 17S. The tool interface defines a reception hole 18RS, a holder shank 17S, a pull stud 18 and a collet 19. That is, the tool interface corresponds to the holder type information indicating the type of the tool holder 17 attachable to the machine tool 1. The collet chucks 19 are configured to open in the radial direction with respect to the rotation axis AX1 when shifted in a first direction DR1 from the pull stud 18 toward the rotary tool T1, and the pull stud 18 can be attached and detached. The collet chucks 19 are configured to be closed in the radial direction with respect to the rotation axis T1 when shifted in a second direction DR2 from the rotary tool T1 toward the pull stud 18, and are fitted to the pull stud 18. The pull stud 18 is fitted into the collet 19, whereby the tool holder 17 is fixed to the spindle 12b. At this time, the key 12K of the spindle 12b is fitted into the groove 17G of the tool holder 17, so that the rotation of the tool holder 17 with respect to the spindle 12b is restricted.

Referring to FIG. 2, the computer 90 is used to execute a model generation program 81 for generating a three dimensional geometric model TM of the tool holder 17 and a three dimensional geometric model HM of the rotary tool T1, an interference determination program 82 for determining whether an assembly model AM obtained by combining the three dimensional geometric model HM of the tool holder 17 and the three dimensional geometric model TM of the rotary tool T1 interferes with the three dimensional geometric model of the workpiece W when executing the machining program 8 for machining the workpiece W to the machine tool 1, and a measurement availability determination program 82a for determining whether the assembly model AM can be moved to the measurement instrument MD for measuring the three dimensional shape of the rotary tool T1.

The computer 90 includes an input device 91a, a display 91b, and a computer main body 92, which have substantially the same functions as those of the input device 10a, a display 10b, and a numerical controller 2, respectively. The computer main body 92 includes a hardware processor 93, a memory 94, a system bus 95, an input/output interface 96, and a communication interface 97, which have substantially the same functions as the hardware processor 3, the memory 4, the system bus 5, the input/output interface 6, and the communication interface 7, respectively. In the following embodiments, the hardware processor 93 may be simply referred to as a processor 93. The memory 4 and the memory 94 may be referred to as storages. The memory 94 of the computer 90 is configured to store a model generation program 81, an interference determination program 82, a measurement availability determination program 82a, a flange definition dataset 83, a holder main body definition dataset 84, a holder shape dataset 85, a machining program 98, and a tool-data 99. The machining program 98 is equal to the machining program 8, and the tool-data 99 is equal to the tool-data 9. In the following embodiments, the tool-data 99 may be referred to as third data defining the shape of the rotary tool T1.

### <Generation of Model of Tool Holder 17>

Next, a specific operation of the model generation program 81 will be described. The processor 93 executing the model generation program 81 regards three dimensional geometric model HM of the holder main body 17MB as equal to an outer diameter DN of the nut 17N or as a predetermined multiple of the outer diameter DN of the nut 17N, and generates an assembly model AM by combining a three dimensional geometric model TM of the rotary tool T1 and the three dimensional geometric model HM of the holder 17. To achieve this, the memory 94 is configured to store flange diameter, and a flange definition data 83 describing at least first data representing the flange diameter DF and the flange length LF. Further, the memory 94 is configured to store holder main body definition data 84 describing a correspondence between the shank diameter DS and the main body diameter DM.

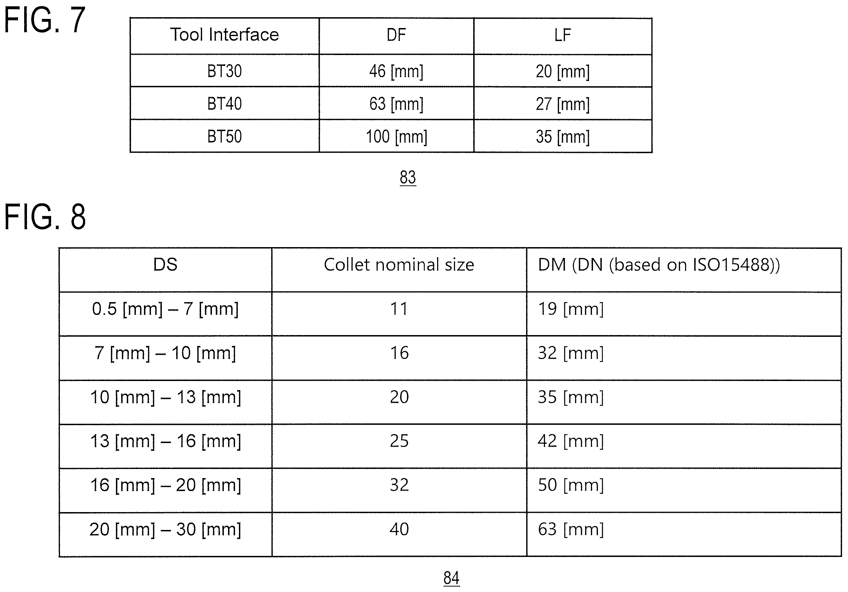

FIG. 7 shows an example of the flange definition data 83. Referring to FIG. 7, the flange definition information 83 includes first information representing tool interfaces supported by the machine tool 1 (spindle 12b), flange diameters DF corresponding to the tool interfaces, and flange lengths LF. That is, the flange definition data 83 represents a correspondence relationship in which the holder type information is associated with the flange diameter DF and the flange length LF corresponding to the holder type information. The flange definition data 83 of FIG. 7 shows a data configuration in a case where the model generation program 81 is designed for general purpose so as to be commonly used in various machine tools 1. The machine tool 1 (spindle 12b) normally supports only one tool interface. Thus, in the case where the model generation program 81 is designed to be customized for each machine tool 1, the first data may be constituted only by the flange diameter DF and the flange length LF.

FIG. 8 shows an example of the holder main body definition data 84. As shown in FIG. 8, the holder main body definition data 84 describes the correspondence between the range of the shank diameter DS shown in the left column and the value of the main body diameter DM shown in the right column. In FIG. 8, for reference, the nominal diameters of the collet 17C corresponding to the ranges of the shank diameter DS shown in the left column are shown in the center column. The ISO15488 standard is set so that even a collet 17C having a large nominal diameter can hold a holder shank 17S having a small shank diameter DS. However, in the example of FIG. 8, the nominal diameter of the collet 17C that can be used is set with respect to a variation range smaller than the variation range of the diameter DIS of the insertion hole 17CIH defined in the ISO15488 standard.

The nominal diameters of the collet 17C corresponding to the ranges of the shank diameter DS is separately disclosed to the operator of the machine tool 1. The main body diameters DM shown in the right column are described as the main body diameters DM used in the model of the outer diameters DN of the nut 17C corresponding to the nominal diameters of the collet 17N in the center column in the ISO15488. However, values customized according to the product conditions of the tool holder 17 on the market may be set. Alternatively, when it is known that a converted value obtained by multiplying the outer diameter DN of the nut 17N portion defined in ISO15488 by a predetermined enlargement factor is empirically shorter than the main body diameter DM of the tool holder on the market, the converted value may be set as the main body diameter DM shown in the right column. The holder shape data 85 stores parameters of the three dimensional geometric model HM of the tool holder 17 generated once by the model generation program 81. The holder shape data 85 will be described in detail later.

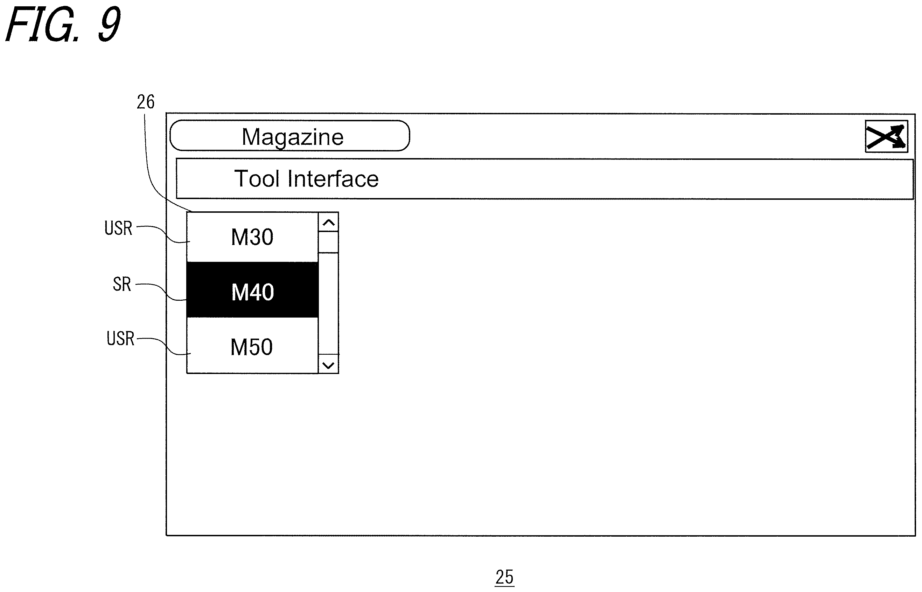

When the model generation program 81 is designed for general purpose so as to be commonly used in various machine tools 1, the processor 93 executing the model generation program 81 receives an input of the tool interface supported by the spindle 12b, that is, the holder type information from the operator via the input interface. FIG. 9 shows an example of the tool interface setting window 25 for receiving an input from the operator of the tool interface supported by the spindle 12b. The tool interface setting window 25 includes a drop-down window 26. FIG. 9 shows an example in which the tool interface of M40 is selected by a well-known method such as a mouse click or a touch on a touch panel. In FIG. 9, the row SR corresponding to the selected M40 is highlighted. The remaining rows are displayed as unhighlighted rows USR. A graphical user interface (GUI) that receives the selection input using the input devices 91a corresponds to the input interface. The tool interface setting window 25 may be selectable by another well-known GUI such as a check box, a radio button, or a drop-down window, instead of such a selection form. Thereafter, the processor 93 executing the model generation program 81 acquires the first data representing the flange diameter DF and the flange length LF corresponding to the input tool interface from the memory 94 (flange definition data 83). That is, the processor 93 executing the model generation program 81 acquires the first data from the memory 94 based on the holder type information. When the model generation program 81 is designed to be customized for each machine tool 1, the GUI display as shown in FIG. 9 and the process of selecting one piece of first data from the flange definition data 83 defining a plurality of tool interfaces are omitted.

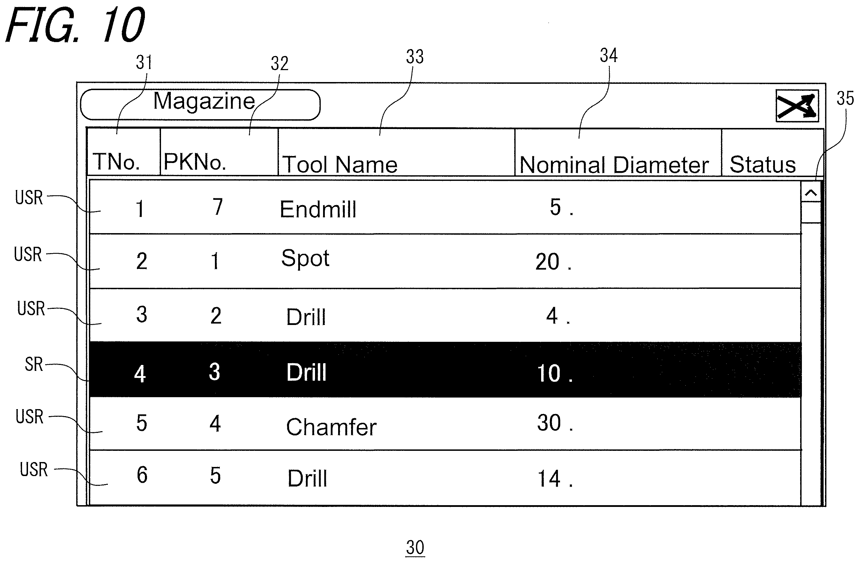

Next, the processor 93 executing the model generation program 81 receives an input of the shank diameter DS from the operator via the input interface. FIG. 10 shows an example of the input interface for the shank diameters DS of the rotary tools T1. FIG. 10 shows the tool display window 30 which displays information such as the shape of each rotary tool T1 stored in the tool-data 99 in a selectable list format. The tool display window 30 includes a drop-down window 35, and the items of the drop-down window 35 are displayed as a T number 31, a pocket number 32, a tool name 33, and a nominal diameter 34 of the tool in order from the left. In the tool display window 30, information other than these pieces of information may be displayed, and at least one piece of information of the T number 31 and the pocket number 32 may be omitted.

FIG. 10 shows an example in which the tool with T number 4 is selected by a known method such as a mouse click or a touch on a touch panel. In FIG. 10, the row SR corresponding to the selected rotary tool T2 is highlighted. The remaining rows are displayed as unhighlighted rows USR. The GUI that receives the selection input by using the input devices 91a corresponds to the input interface. The tool display window 30 may be selectable by another well-known GUI such as a check box, a radio button, or a drop-down window, instead of such a selection form.

The processor 93 executing the model generation program 81 acquires the shank diameter DS corresponding to the tool name 33 selected in the tool display window 30 and the nominal diameter 34 of the tool from the tool-data 99. Further, the processor 93 executing the model generation program 81 acquires second data representing the main body diameter DM corresponding to the shank diameter DS obtained from the memory 94 storing the holder main body definition data 84. The processor 93 executing the model generation program 81 acquires the tool diameter DT and the included angle (at least a part of the third data) corresponding to the tool name 33 selected in the tool display window 30 and the nominal diameter 34 of the tool from the memory 94.

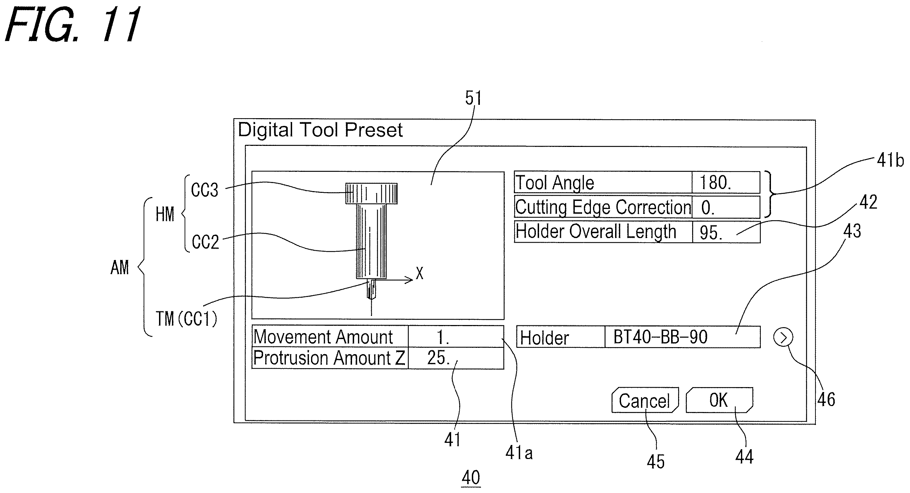

Next, the processor 93 executing the model generation program 81 receives an input of the main body length LM from the operator via the input interface. FIG. 11 shows an example of an input interface for the main body length LM of the tool holder 17. FIG. 11 shows a dimension input window 40 which is a part of the input interface. The size input window 40 includes a first text box 41 for inputting the tool-length offset LT, a movement-amount text box 41a for adjusting the upper limit of the numerical value in the first text box 41, a first additional text box 41b for inputting the shape characteristics of the tool other than the tool-length offset LT, a second text box 42 for inputting the holder total length LH, a third text box 43 for displaying/editing the name of the tool holder 17, an OK button 44, a cancel button 45, and a model display screen 51.

The first text box 41 for inputting the tool-length offset LT, the movement-amount text box 41a, the first additional text box 41b for displaying the shape characteristics of the tools other than the tool-length offset LT, and the second text box 42 for inputting the holder total length LH are text boxes in which numerical values can be input. When the up or down arrow button is touched or clicked in a state where the first text box 41 is selected, the numerical value displayed in the first text box 41 is increased or decreased by the numerical value of the movement-amount text box 41a. The numerical value in the first text box 41 can be changed by directly inputting the numerical value. When the name 33 is selected, the first additional text box 41b displays a parameter representing a unique shape of the name 33 obtained from the tool-data 99. The numerical values displayed in the first additional text box 41b are usually displayed in an unchangeable form, but may be made editable by the operator for convenience in generating the three dimensional geometric model TM of the rotary tools T1. However, even when the tool-data 99 is edited in this way, the tool-data 99 is not modified.

The processor 93 executing the model generation program 81 receives an input of the holder total length LH obtained by adding the flange length LF to the main body length LM from the operator via the input interface. An interface that receives a numerical input to the second text box 42 by using the input devices 91a corresponds to the input interface. The processor 93 obtains the main body length LM by subtracting the flange length LF from the holder total length LH. Further, the processor 93 executing the model generation program 81 receives an input of the tool length offset LT from the operator via the input interface. An interface that receives a numerical input to the second text box 41 by using the input device 91a corresponds to the input interface.

When a numerical value is input to the second text box 42, the processor 93 executing the model generation program 81 sets the numerical value as the holder overall length LH, obtains the body length LM from the flange length LF, the flange diameter DF, and the holder overall length in the flange definition data 83, and searches whether the three dimensional geometric model HM of the tool holder 17 having the main body diameter DM obtained from the shank diameter DS and the obtained body length LM is stored in the holder shape data 85. When the three dimensional geometric model HM of the tool holder 17 is stored in the holder shape data 85, the processor 93 executing the model generation program 81 acquires the stored three dimensional geometric model HM. When the three dimensional geometric model HM of the tool holder 17 is stored in the holder shape data 85, the processor 93 executing the model generation program 81 acquires the stored three dimensional geometric model HM. When the three dimensional geometric model HM is not stored in the holder shape data 85, the processor 93 executing the model generation program 81 generates the three dimensional geometric model HM of the tool holder 17 based on the obtained body length LM, main body diameter DM, flange length LF, and flange diameter DF. When a numerical value is input to the second text box 41, the processor 93 executing the model generation program 81 sets the numerical value as the holder overall length LH, obtains the body length LM from the flange length LF, the flange diameter DF, and the holder overall length in the flange definition data 83, and searches whether the three dimensional geometric model HM of the tool holder T1 having the main body diameter DM obtained from the shank diameter DS and the obtained body length LM is stored in the holder shape data TM. The tool-data 99 may include a recommended amount of protrusion, and in this case, the recommended amount of protrusion may be input as a default value of the numerical value of the first text box 41. The processor 93 executing the model generation program 81 generates an assembly model AM by combining the three dimensional geometric model TM of the rotary tools T1 and the three dimensional geometric model HM of the tool holder 17.

In detail, the three dimensional geometric model TM of the rotary tool T1 is formed of a first circular column CC1 having a tool diameter DT as a diameter and a tool length offset LT. The three dimensional geometric model HM of the tool holder 17 is composed of a second circular column CC2 having a main body diameter DM and a body length LM, and a third circular column CC3 having a flange diameter DF as a diameter and a flange length LF. The processor 93 executing the model generation program 81 displays the assembly model AM generated in this way on the model display screen 51. That is, the processor 93 executing the model generation program 81 generates a signal to the display 91b so as to display the three dimensional geometric model HM of the tool holder 17 on the display 91b. The processor 93 executing the model generation program 81 generates a signal to the display 91b so as to display the three dimensional geometric model TM of the rotary tool T1 on the display 91b. The processor 93 executing the model generation program 81 generates a signal to the display 91b so as to display the assembly model AM on the display 91b.

When the numerical value is entered in the second text box 42, the processor 93 executing the model generation program 81 displays the holder name of the three dimensional geometric model HM of the tool holder 17 displayed on the display 91b in the third text box 43. The third text box 43 may be omitted.

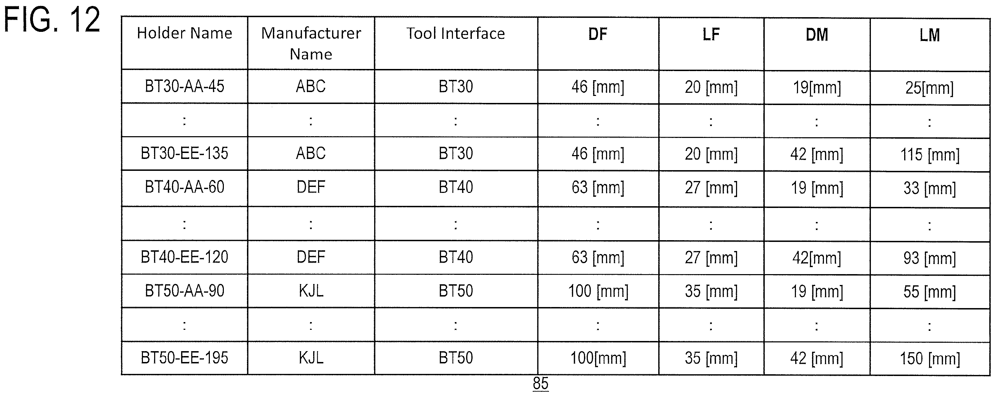

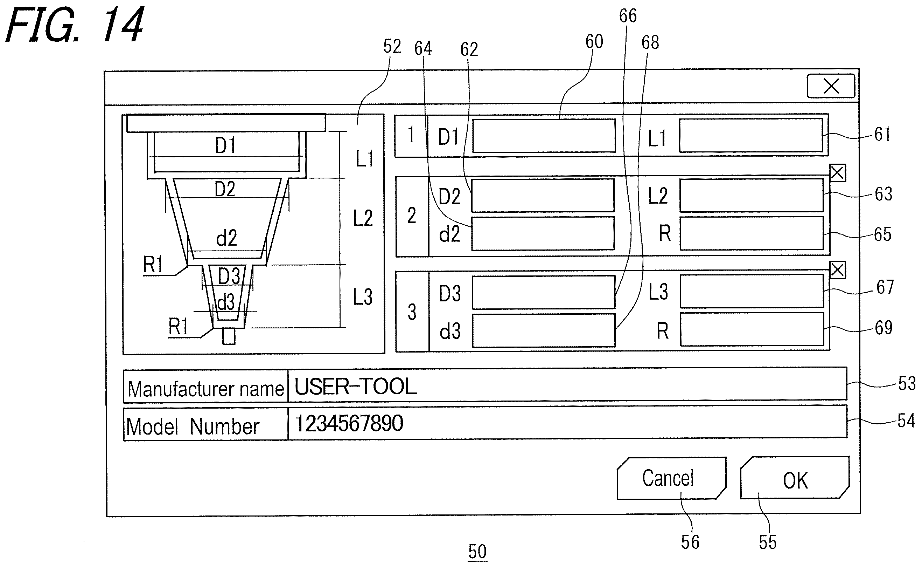

FIG. 12 shows an example of the holder shape data 85. The holder shape data 85 includes a holder name of the tool holder 17, a manufacturer name of the tool holder 17, a tool interface, a flange diameter DF, a flange length LF, a main body diameter DM, and a body length LM. The holder shape data 85 further includes a holder name of the tool holder 17 and extended holder diameters d2, D3, d3, extended holder length L3, a first R size R1, a second R size R2. The holder name may be a model number by a manufacturer or a name appropriately assigned by an operator. The manufacturer name can be set by an interface (a fourth text box 53 in FIG. 14) described later. The extension holder diameters d2, D3, and d3, the extension holder lengths L3, the first R dimensions R1, and the second R dimension R2 correspond to the lengths of portions displayed on an input instruction screen 52 of FIG. 14 described later. In the example of FIG. 12, a plurality of tool holders 17 related to different tool interfaces are displayed, but in the case where the model generation program 81 is designed for general purpose so as to be commonly used in various machine tools 1 and the model generation program 81 is designed to be customized for each machine tool 1, the holder shape data 85 may not include the element of the tool interface and may include only a plurality of tool holders 17 having tool interfaces supported by the machine tool 1. A part of the holder shape information 85 may be created and provided in advance by a provider who provides the model generation program 81, the interference determination program 82, and the measurement availability determination program 82a.

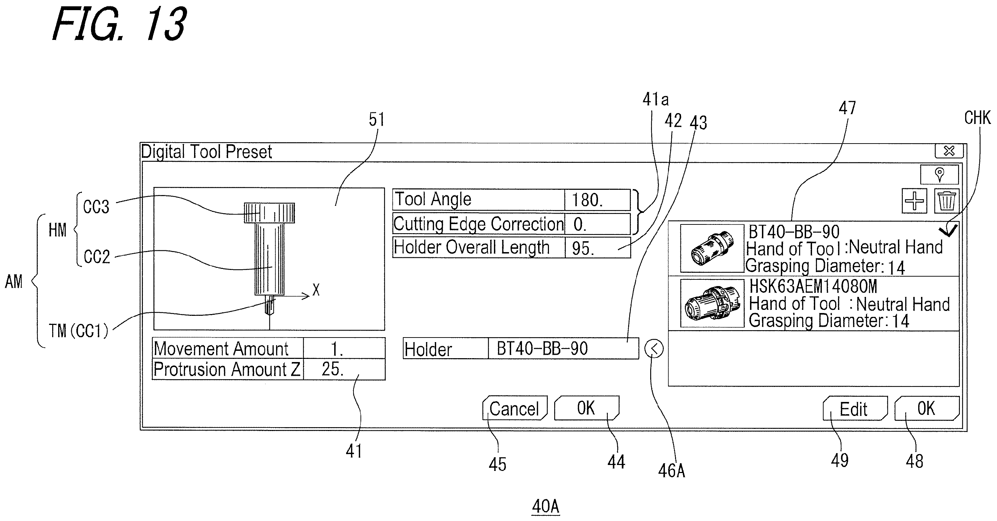

Returning to FIG. 11, the dimension input window 40 further includes a detail setting button 46. When the operator wants to construct a model more detailed than the assembly model AM, the operator can display an addition menu by pressing the detail setting button 46. Referring to FIG. 13, the size input window 40A including the additional menu includes a tool holder selection window 47, an OK button 48, and an edit button 49 in addition to the contents displayed in the size input window 40. In the size input window 40A, the arrowhead of the detail setting button 46A is displayed in the opposite direction to the arrowhead of the detail setting button 46 of the size input window 40. When the detail setting button 46A is clicked, the display returns to the display of the size input window 40 of FIG. 9.

Tool holder selection window 47 displays at least one tool holder 17 having a main body diameter DM, a body length LM, a flange diameter DF, and a flange length LF to be set in a selectable manner. In the tool holder selection window 47, at least one tool holder 17 is displayed in a list form, and one of the at least one tool holder 17 is highlighted when selected by a well-known method such as touch or click. When the OK button 48 is pressed, the check mark CHK is displayed on the selected tool holder. Then, the holder name of the selected tool holder 17 is displayed in the third text box 43. The tool holder selection window 47 does not necessarily display the same shape as the tool holder 17 having the set main body diameter DM, body length LM, flange diameter DF, and flange length LF, but may display the 3D information received from the manufacturer of the tool holder 17. As the holder shape data 85, the main body diameter DM, the body length LM, the flange length LF, and the flange diameter DF of the tool holder 17 displayed as different shapes are stored as the main body diameter DM, the main body length LM, the flange diameter DF, and the flange length LF to be set. Therefore, the interference determination program 82 and the measurement availability determination program 82a, which will be described later, are executed by using the assembly model AM having the same shape as the tool holder 17 displayed on the model display screen 51.

When the edit button 49 is pressed, the processor 93 executing the model generation program 81 displays the detailed shape input screen 50. Referring to FIG. 14, the detailed shape input screen 50 includes an input instruction screen 52, a fourth text box 53, a fifth text box 54, an OK button 55, a cancel button 56, and sixth to fifteenth text boxes 60 to 69. The input instruction screen 52 allows the user to input which part of the tool holder 17 has a length corresponding to the indicator displayed on the left side of each of the sixth to fifteenth text boxes 60 to 69. That is, as shown in the input instruction screen 52, the three dimensional shape of the tool holder 17 modeled as a combination of two truncated cones can be set via the detailed shape input screen 50.

The fifth text box 54 is a GUI for receiving an input of the holder name of the tool holder 17. The fourth text box 53 displays the manufacturer name of the tool holder 17. The fourth text box 53 and the fifth text box 54 are initially displayed in a blank state. The sixth text box 60 is a GUI for receiving an input of the flange diameter DF, and a value of the flange diameter DF to be set is displayed as an initial value. The seventh text box 61 is a GUI that receives an input of a flange length LF, in which the value of the flange length LF to be set is displayed as an initial value. The eighth text box 62 is a GUI for receiving an input of the main body diameter DM, in which a value of the main body diameter DM to be set is displayed as an initial value. The ninth text box 63 is a GUI for receiving an input of the main body length LM, in which the value of the body length LM to be set is displayed as an initial value. The tenth to fifteenth text boxes 64 to 69 are set to 0 as an initial value. When any one of the numerical value of the seventh text box 61, the numerical value of the ninth text box 63, and the numerical value of the thirteenth text box 67 is corrected, the numerical values of the remaining text boxes are corrected so that the sum of the numerical values becomes the numerical value of the second text box 42.

The processor 93 executing the model generation program 81 receives an input of the correction value of at least one of the flange diameter DF (D1 in FIG. 14), the flange length LF (L1 in FIG. 14), the main body diameter DM (D2 in FIG. 14), and the main body length LM (L2 in FIG. 14) via the input interface. A GUI that receives numerical inputs to the sixth to ninth text boxes 60 to 63 by using the input device 91a corresponds to the input interface. When the OK button 55 is pressed in a state where the manufacturer name of the tool holder 17 is input in the fourth text box 53, the holder name of the tool holder 17 is input in the fifth text box 54, and the corresponding numerical values are input in the sixth to fifteenth text boxes 60 to 69, the processor 93 executing the model generation program 81 newly registers the dataset of the tool holder 17 having the holder name displayed in the fifth text box 54, the manufacturer name of the tool holder 17 displayed in the fourth text box 53, the main body diameter DM (D2), the main body length LM (L2), the flange diameter DF (D1), the flange length LF (L1), the expanded holder diameter d2, D3, d3, the expanded holder length L3, the first R size R1, and the second R size R2 in the holder shape database 85, and closes the detailed shape input screen 50. An example of the holder shape data 85 newly registered in this way is displayed in the lowermost row of FIG. 12. Note that, as the tool interface here, a tool interface supported by the machine tool 1 (for example, an interface selected by a GUI as shown in FIG. 9) is automatically inserted. When the cancel button 56 is pressed, the processor 93 executing the model generation program 81 closes the detailed shape input screen 50 without registering the data set in the detailed shape input screen 50 in the holder shape data 85.

When the detailed shape input screen 50 is closed, the processor 93 executing the model generation program 81 adds the information of the tool holder 17 newly registered in the holder shape data 85 to the tool holder selection window 47. If the information is selected and the OK button 48 is pressed, the processor 93 executing the model generation program 81 generates the three dimensional geometric model HM of the tool holder 17 on the model display screen 51 based on the numerical values input to the sixth to fifteenth text boxes 60 to 69, and regenerates the assembly model AM. That is, when at least one correction value is input, the processor 93 executing the model generation program 81 regenerates the three dimensional geometric model HM of the tool holder 17 based on the at least one correction value. The regenerated three dimensional geometric model HM of the tool holder 17 is displayed on the model display screen 51. Then, the processor 93 executing the model generation program 81 updates the third text box 43 to the name set by the fifth text box 54.

In this way, when the assembly model AM is displayed on the model display screen 51, the assembly model AM is regenerated by correcting the values of the first text box 41 and the second text box 42 or correcting the values of the sixth to fifteenth text boxes 60 to 69, pressing the OK button 55, selecting the corrected tool holder 17 in the tool holder selection window 47, and pressing the OK button 48. Therefore, the processor 93 executing the model generation program 81 receives an input of the correction value of at least one of the flange diameter DF, the flange length LF, the main body diameter DM, the body length LM, and the tool length offset LT via the input interface described above. Then, when at least one correction value is input, the processor 93 executing the model generation program 81 regenerates the assembly model AM based on the at least one correction value. When the OK button 44 is pressed after the above processing is finished, the processor 93 executes the following interference determination program 82 and measurement availability determination program 82a based on the assembly model AM displayed on the model display screen 51 at that time. When the cancel button 45 is pressed, the processor 93 ends the model generation program 81 without setting the assembly model AM.

### <Interference Determination Program 82, Operation of Measurement availability determination program 82a>

Next, the operation of the interference determination program 82 and the measurement availability determination program 82a in FIG. 2 will be described. The processor 93 that executes the interference determination program 82 acquires the geometric model of the obstacle from the memory 94. That is, the memory 94 stores the geometric model of the obstacle together with the interference determination program 82. The obstacle refers to an object other than the workpiece W disposed on the machining table 11, such as a jig for fixing the workpiece W to the machining table 11. In addition, when the workpiece W is in contact with the tool holder 17 or the spindle 12b, the workpiece W may also become the obstacle. The processor 93 that executes the interference determination program 82 determines whether or not the assembly model AM and the geometric model of the obstacle collide with each other when the machining program 98 for machining the workpiece W by driving the spindle 12b is executed by the machine tool 1. For example, the interference determination program 82 is executed at each time during the execution of the machining program 98 such that the position of the geometric model of the assembly model AM and the obstacle is calculated, and it is determined whether the assembly model AM interferes with the geometric model of the obstacle at each time. Here, the interference means contact between the assembly model AM and the geometric model of the obstacle other than contact between the rotary tool T1 and the workpiece W. For example, interference also occurs when the tool length offset LT is too short and the tool holder 17 comes into contact with the workpiece W. The interference determination program 82 makes it possible to simulate in advance whether or not there is interference of the obstacle when the machine tool 1 executes the machining program 98, and to check in advance by simulation the size of the tool length offset LT to the extent that the tool holder 17 does not interfere with the workpiece W.

The processor 93 that executes the measurement availability determination program 82a acquires the geometric model of the obstacle including the measurement instrument MD that stores the tool-length offset LT from the memory 94. The processor 93 that executes the measurement availability determination program 82a determines whether the geometric model of the assembly model AM and the geometric model of the obstacle interfere with each other before the geometric model of the rotary tool T1 reaches the predetermined position of the measurement instrument MD when the processor 93 causes the measurement instrument MD to execute the moving program of the rotary tool T1 for measuring the rotary tool T1. Therefore, the memory 94 stores the movement program and the geometric model of the obstacle together with the measurement availability determination program 82a. The predetermined position is, for example, a position of the measurement instrument MD into which the rotary tools T1 are inserted in the measurement of the rotary tools T1 by the measurement instrument MD. The obstacle indicates, for example, an object other than a portion provided at a predetermined position of the measurement instrument MD. For example, the measurement availability determination program 82a calculates the positions of the assembly model AM and the geometric model of the obstacle at each time during the execution of the movement program, and determines whether the assembly model AM interferes with the geometric model of the obstacle at each time. The interference means contact between the assembly model AM and the obstacle other than contact between the rotary tool T1 and the parts provided at the predetermined position of the measurement instrument MD.

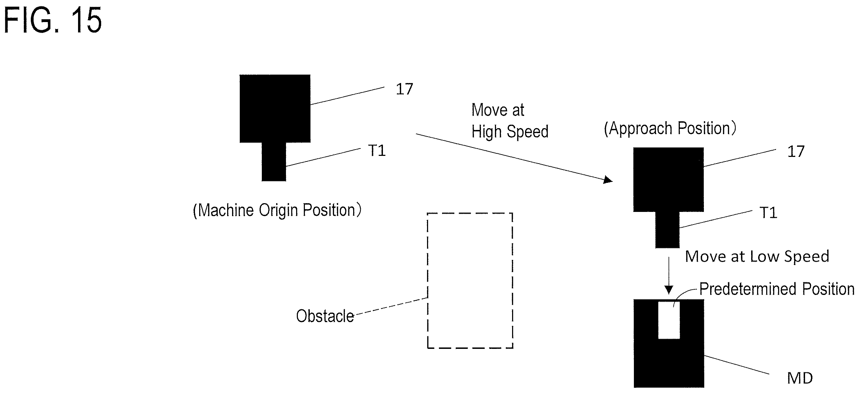

FIG. 15 is a conceptual diagram showing the movement of the rotary tool T1 to the measuring device MD. As shown in FIG. 15, the rotary tool T1 is moved from the machine origin to a predetermined position of the measurement instrument MD. At this time, the rotary tool T1 is moved at high speed to an approach position near the measurement instrument MD and moved at low speed from the approach position. However, if information on the obstacle in the middle is unknown, it is necessary to provide an approach position at a distant position for safety, or to move the rotary tool T1 at a medium or low speed from the machine origin to the approach position while the operator is looking inside the machine, which causes a problem that it takes a long time for measurement. However, if the movement of the rotary tool T1 is simulated in advance by the measurement availability determination program 82a, the approach position can be provided very close to the measurement instrument MD or the moving speed from the machine origin to the approach position can be increased. Therefore, the measurement time can be shortened.

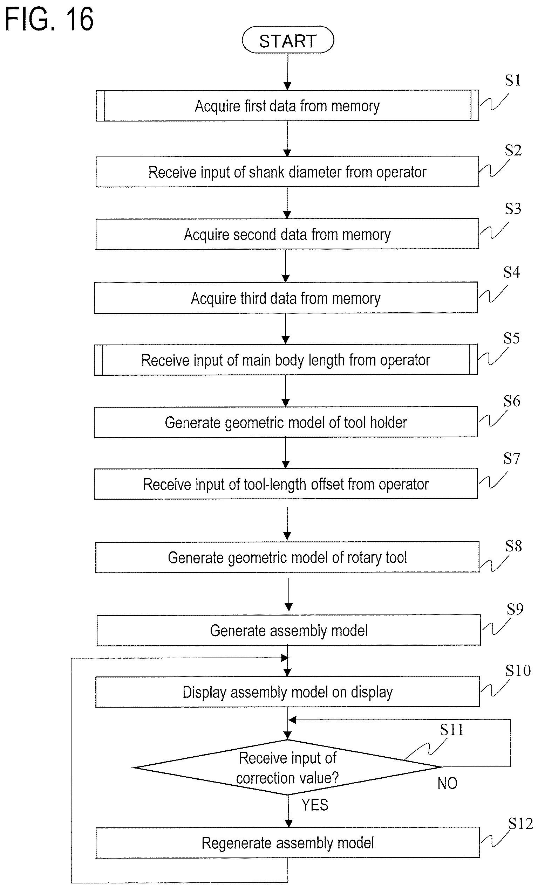

Next, the operation of the model generation program 81 shown in FIG. 2 will be described in detail. FIG. 16 is a flowchart showing the details of the operation of the model generation program 81. The model generation program 81 includes instructions that, when executed by the processor 93 of the computer 90, cause the processor 93 to execute processing of a model generation method described in FIGS. 16 and 17 to 18 accompanying FIG. 16. Referring to FIG. 16, in step S1 of the model generation method, the processor 93 executing the model generation program 81 acquires first data representing the flange diameter DF and the flange length LF from the memory 94 (storage).

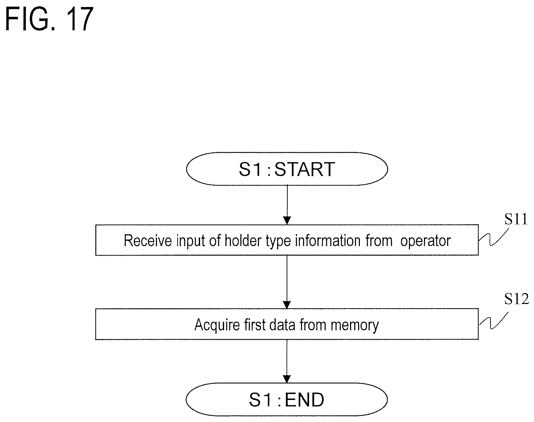

FIG. 17 is a flowchart showing the details of the operation in step S1. FIG. 17 shows an operation example in a case where the model generation program 81 is designed for general purpose so as to be commonly used in various machine tools 1. Referring to FIG. 17, in step S11, the processor 93 executing the model generation program 81 receives an input of the holder type information (tool interface) from the operator via the input interface (for example, a GUI for receiving a selection input of a tool interface using the input devices 91a in the tool interface setting window 25). In step S12, the processor 93 executing the model generation program 81 acquires the first data based on the holder type information (tool interface) from the memory 94 (storage) storing the correspondence relationship in which the holder type information (tool interface) is associated with the flange diameters DF and the flange lengths LF corresponding to the holder type information (tool interface). In the case where the model generation program 81 is designed to be customized for each machine tool 1, the first data representing the flange diameter DF and the flange length LF defined by the tool interface supported by the machine tool 1 (spindle 12b) may be acquired from the memory 94 (storage).

Referring again to FIG. 16, in step S2 of the model generation method, the processor 93 executing the model generation program 81 receives an input of the shank diameter DS from the operator via the input interface (GUI for receiving a selection input of the tool display window 30 using the input interface 91a). In step S3 of the model generation method, the processor 93 executing the model generation program 81 acquires the second data representing the main body diameter DM corresponding to the acquired shank diameter DS from the memory 94 (storage) storing the holder main body definition data 84. In step S4 of the model generation method, the processor 93 executing the model generation program 81 acquires the third data defining the shape of the rotary tool T1 from the memory 94 (storage) storing the tool-data 99. In step S5 of the model generation method, the processor 93 executing the model generation program 81 receives an input of the main body length LM from the operator via the input interface (GUI for receiving a numerical input of the size input window 40 using the input devices 91a).

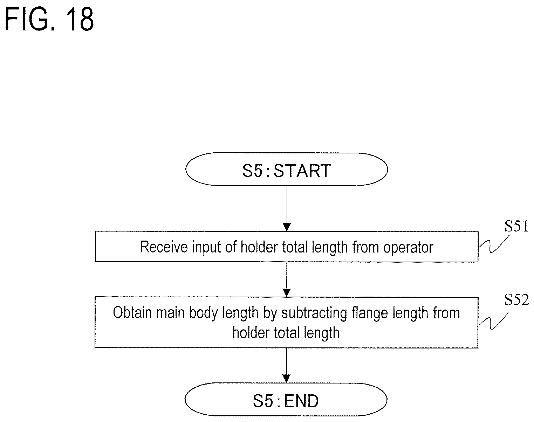

FIG. 18 is a flowchart showing the details of the operation in step S5. Referring to FIG. 18, in step S51, the processor 93 executing the model generation program 81 receives an input of the holder total length LH from the operator via the input interface (GUI for receiving a numerical input to the second text box 42 using the input interface 91a). In step S52, the processor 93 executing the model generation program 81 obtains the main body length LM by subtracting the flange length LF from the holder total length LH.

Referring again to FIG. 16, in step S6 of the model generation method, the processor 93 executing the model generation program 81 generates the three dimensional geometric model HM of the tool holder 17 based on the main body length LM acquired in step S5, the first data acquired in step S1, and the second data acquired in step S3. In step S7 of the model generation method, the processor 93 executing the model generation program 81 receives an input of the tool-length offset LT from the operator via the input interface (GUI for receiving a numerical input in the first text box 41 using the input devices 91a). Note that, when the tool-data 99 includes a recommended protrusion amount and the tool-length offset LT is automatically set to the recommended protrusion amount, step S7 may be omitted. In step S8 of the model generation method, the processor 93 executing the model generation program 81 generates the three dimensional geometric model TM of the rotary tool T1 based on the obtained tool-length offset LT and the third data obtained in step S4.

In step S9 of the model generation method, the processor 93 executing the model generation program 81 generates an assembly model AM by combining the three dimensional geometric model TM of the rotary tool and the three dimensional geometric model HM of the tool holder 17. In step S10 of the model generation method, the processor 93 executing the model generation program 81 generates a signal to the display 91b so as to display the assembly model AM (the three dimensional geometric model HM of the tool holder 17) on the display 91b. In step S11 of the model generation method, the processor 93 executing the model generation program 81 receives an input of the correction value of at least one of the flange diameter DF, the flange length LF, the body diameter DM, the body length LM, and the tool-length offset LT via the input interface (GUI for receiving a numerical input of the dimension input window 40 using the input devices 91a). When there is no input (No in step S11), step S11 is repeated. When at least one correction value is input (Yes in step S11), the processor 93 executing the model generation program 81 regenerates the assembly model AM based on the at least one correction value in step S12 of the model generation method. After the end of step S12, the process returns to step S10.

### <Features and Effects of Model Generation Method in Present Embodiment>

The model generation method, the model generation program 81, and the computer 90 executing the model generation program 81 according to the present embodiment receive the operator's input of the shank diameter DS of the rotary tool T1, and cause the processor 93 to acquire the second data representing a main body diameter DM corresponding to the acquired shank diameter DS from the memory 94 storing the holder main body definition information 84 describing the correspondence between the shank diameter DS of the rotary tool T1 and the main body diameter DM of the holder main body 17MB, and thereby utilizing, generates the three dimensional geometric model HM of the tool holder 17 . Therefore, the model generation method, the model generation program 81, and the computer 90 executing the model generation program 81 can generate the geometric model of the tool holder 17 more easily than in the related art.

### <Modification>

Although the above embodiment shows a GUI such as the tool display window 30 and the dimension input window 40 as an example of the input interface, a different interface such as a character user interface (CUI) for setting by a command may be used.

In the above-described embodiment, an example in which the machine tool 1 is a vertical machining center is described, but the contents of the present embodiment can also be applied to a machine tool 1 in which the machine tool 1 includes a horizontal machining center, a lathe, and an additive manufacturing apparatus.

Some or all of the functions of the logics of the model generation program 81, the interference determination program 82, and the measurement availability determination program 82a of the computer 90 described above may be realized by dedicated processors or integrated circuits. The model generation program 81, the interference determination program 82, and the measurement availability determination program 82a may be stored in a storage media that is removable from the computer 90 and readable by the computer 90, such as disks including floppy disks, optical disks, CD-ROMs, and magnetic disks, SD cards, USB-memories, and external hard disks, in addition to the memory 94 built in the computer 90.

In this application, the word "comprise" and its derivatives are used as open-ended terms to describe the presence of elements but not to exclude the presence of other elements not listed. This applies to "having", "including" and derivatives thereof.

The terms "member", "part", "element", "body", and "structure" may have a plurality of meanings, such as a single portion or a plurality of portions.

The ordinal numbers such as "first" and "second" are merely terms for identifying the configuration, and do not have other meanings (for example, a specific order). For example, the presence of a "first element" does not imply the presence of a "second element," and the presence of a "second element" does not imply the presence of a "first element."

Terms of degree such as "substantially", "about", and "approximately" can mean a reasonable amount of deviation such that the end result is not significantly changed, unless the embodiment is specifically described otherwise. All numerical values recited herein may be construed to include terms such as "substantially," "about," and "approximately."

The phrase "at least one of A and B" as used herein should be interpreted to include A alone, B alone, and both A and B.

Obviously, numerous modifications and variations of the present invention are possible in light of the above teachings. Thus, it is to be understood that the invention may be practiced otherwise than as specifically described herein without departing from the scope of the invention.

## Claims

1. A model generation method comprising:
causing a processor to obtain from a storage, first data specifying:
a flange diameter that is a diameter of a flange of a tool holder in a radial direction with respect to a central axis, the tool holder comprising:
the flange formed around the central axis; and
a holder main body which extends from the flange in an axial direction along the central axis and to which a rotary tool is attachable; and
a flange length that is a length of the flange in the axial direction;
causing the processor to receive inputs of a shank diameter of the rotary tool and a main body length from an operator via an input interface, the main body length being a length of the holder main body in the axial direction;
causing the processor to obtain from the storage that stores correspondence between the shank diameter and a main body diameter that is a diameter of the holder main body in the radial direction, second data specifying the main body diameter corresponding to the shank diameter that has been received; and
causing the processor to generate a geometric model of the tool holder based on the first data, the second data, and the main body length that has been received.

2. The model generation method according to claim 1.
wherein the causing the processor to receive the input of the main body length from the operator includes:
causing the processor to receive from the operator an input of a holder overall length that is a sum of the main body length and the flange length; and
causing the processor to obtain the main body length by subtracting the flange length from the holder total length.

3. The model generation method according to claim 1 or 2. wherein the causing a processor to obtain the first data includes:
causing the processor to receive, via the input interface, from the operator, an input of holder type information specifying a type of tool holder attachable to a machine tool; and
causing the processor to obtain the first data based on the holder type information from the storage that stores correspondence that associates the holder type information with the flange diameter and the flange length corresponding to the holder type information.

4. The model generation method according to claim 3,
wherein the tool holder has a holder shank opposite to the holder main body with respect to the flange in the axial direction,
wherein the spindle has a reception hole into which the holder shank is insertable,
wherein whether or not the plurality of the tool holders are attachable to the machine tool is determined based on whether or not the reception hole fits with the holder shank.

5. The model generation method according to any one of claims 1 to 4,
wherein the main body diameter is equal to an outer diameter of a nut with which the rotary tool is fastened to the holder main body.

6. The model generation method according to claim 5,
wherein the nut is configured to fasten a collet that is press-fittable onto the rotary tool that has the shank diameter.

7. The model generation method according to claim 6,
wherein the outer diameter of the nut is determined to a dimension corresponding to a size of the collet that fits with the shank diameter in accordance with the ISO15488 standard.

8. The model generation method according to any one of claims 1 to 7, further comprising:
causing the processor to generate a signal to a display to cause the display to display the geometric model of the tool holder;
causing the processor to receive via the input interface from the operator, an input of at least one revised value of the flange diameter, the flange length, the main body diameter, and the main body length; and
causing the processor to regenerate the geometric model of the tool holder based on the at least one revised value when the at least one revised value is input.

9. The model generation method according to any one of claims 1 to 8, further comprising:
causing the processor to receive via the input interface from the operator, an input of a tool-length offset, which is a length of a protrusion of the rotary tool from the nut;
causing the processor to acquire from the storage, third information defining a shape of a rotary tool;
causing the processor to generate a geometric model of the rotary tool based on the tool-length offset and the third data; and
causing the processor to generate an assembly model by combining the geometric model of the rotary tool and the geometric model of the tool holder.

10. The model generation method according to claim 9, further comprising:
causing the processor to generate a signal to a display to cause the display to display the assembly model;
causing the processor to receive via the input interface, an input of at least one revised value of the flange diameter, the flange length, the main body diameter, the main body length, and the tool-length offset;
causing the processor to regenerate the assembly model based on the at least one revised value upon the input of the at least one revised value.

11. A determination method comprising:
the model generation method according to claim 9 or 10;
causing the processor to acquire from the storage, a geometric model of an obstacle including a measurement instrument configured to measure the tool-length offset; and
causing the processor to determine whether or not the assembly model and the geometric model of the obstacle interfere with each other before the geometric model of the rotary tool reaches a predetermined position of the measurement position when executing a moving program of the rotary tool so as to have the rotary tool measured by the measurement instrument.

12. A determination method comprising:
the model generation method according to claim 9 or 10;
causing the processor to acquire a geometric model of an obstacle from the storage; and
causing the processor to determine whether or not the assembly model and the geometric model of the obstacle interfere with each other when the machine tool is caused to execute a machining program to machine the workpiece by driving the spindle.

13. A computer comprising:
a processor configured to execute the model generation method according to any one of claims 1 to 10 or the determination method according to claim 11 or 12;
the storage; and
the input interface.

14. A machine tool system comprising:
the computer according to claim 13; and
the machine tool including the spindle to which the tool holder is attachable.

15. A computer program comprising instructions which, when executed by a computer with the input interface, cause the computer to carry out the model generation method according to any one of claims 1 to 10 or the determination method according to claim 11 or 12.
